Europäisches Patentamt

European Patent Office

Office européen des brevets

(19)

(11) Numéro de publication : **0 119 134 B1**

## FASCICULE DE BREVET EUROPÉEN

(12)

(45) Date de publication du fascicule du brevet :
29.07.87

(51) Int. Cl.⁴ : **H 01 L 25/12, H 05 K   7/20**

(21) Numéro de dépôt : **84400444.0**

(22) Date de dépôt : **06.03.84**

(54) **Dispositif d'assemblage de composants électroniques de puissance sur un dissipateur thermique et application aux ponts monophasés ou polyphasés.**

(30) Priorité : **07.03.83 FR 8303681**

(43) Date de publication de la demande :
**19.09.84 Bulletin 84/38**

(45) Mention de la délivrance du brevet :
**29.07.87 Bulletin 87/31**

(84) Etats contractants désignés :
**AT BE CH DE GB IT LI LU NL SE**

(56) Documents cités :
**FR-A- 2 477 828
GB-A- 1 516 046
US-A- 4 322 776
ELECTRONICS, vol. 52, no. 9, 26 avril 1979, pages 67-68, New York, US K. SMITH: "Bonding hybrids to heat sinks cuts weight, volume"**

(73) Titulaire : **LA TELEMECANIQUE ELECTRIQUE
33 bis, avenue du Maréchal Joffre
F-92000 Nanterre (FR)**

(72) Inventeur : **Sacco, Roger
5, Avenue Saint Exupéry
F-06800 Cagne sur Mer (FR)**

(74) Mandataire : **Marquer, Francis et al
CABINET MOUTARD 35, avenue Victor Hugo Résidence Champfleury
F-78180 Voisins-le-Bretonneux (FR)**

EP 0 119 134 B1

Jouve, 18, rue St-Denis, 75001 Paris, France

## Description

La présente invention concerne un dispositif d'assemblage de composants électroniques de puissance pour dissipateur thermique selon le préambule de la revendication 1.

Il est connu de monter des composants électroniques de puissance sur des dissipateurs thermiques ; mais en général, ces montages nécessitent : des usinages précis pour assurer un bon contact thermique et parfois électrique entre le composant et le dissipateur ; des isolants coûteux et difficiles à monter lorsque l'on veut isoler électriquement le composant du dissipateur. Dans ce dernier cas, l'isolant est en général limité à la surface d'appui du composant et augmente considérablement la résistance thermique entre le composant et le dissipateur. Par ailleurs, pour maintenir la résistance thermique dans des limites raisonnables, on cherche à obtenir un contact thermique aussi bon que possible entre le composant, l'isolant et le dissipateur, tout en assurant un bon maintien de l'ensemble.

En général, les composants étant montés au moyen de vis ou de rivets, on sera amené à augmenter le nombre de points de maintien et, par conséquent, le nombre d'usinages supplémentaires dans le composant, l'isolant et le dissipateur.

La conséquence de ces usinages est une diminution des surfaces en contact.

Comme les rivets et les vis doivent être, soit en matière isolante, soit munis de canons isolants, cela complique les opérations de montage et diminue la transmission de la chaleur.

Enfin, les dispositifs connus nécessitent un câblage important pour relier mutuellement les composants de façon à constituer des ponts monophasés ou polyphasés et les raccorder aux circuits extérieurs.

L'invention a pour but de pallier tout ou partie des inconvénients exposés ci-dessus.

Selon GB-A-1 516 046, il est connu de monter des composants électroniques de puissance directement sur une plaque entièrement métallique reliée à une source d'alimentation.

US-A-4 322 776 enseigne qu'il est possible de monter, au moyen de ressorts, des plaques de circuits imprimés dans des rainures que comporte un bloc dissipateur thermique.

A partir de cet état antérieur de la technique, l'invention propose la réalisation d'un dispositif d'assemblage de composants électroniques sur un dissipateur, qui augmente de façon appréciable, par rapport aux réalisations de l'art antérieur, le contact thermique entre la source de chaleur et le dissipateur et qui soit économique et fiable, c'est-à-dire dans lequel on a limité les usinages tout en permettant un bon maintien des surfaces en contact.

Un autre but de l'invention est l'utilisation d'un tel dispositif pour la réalisation de ponts monophasés ou polyphasés en réduisant les problèmes de câblage pour diminuer les coûts et augmenter la fiabilité.

L'invention, telle qu'elle est caractérisée dans les revendications atteint ces objectifs.

D'autres caractéristiques et avantages de l'invention apparaîtront plus clairement à la lecture de la description ci-après, faite en référence aux dessins annexés, dans lesquels :

La figure 1 est une vue schématique, en coupe et en perspective d'un dispositif d'assemblage d'un composant de puissance sur un dissipateur ;

La figure 2 est une vue de dessus d'une variante du dispositif d'assemblage, utilisant un deuxième mode de fixation ;

Les figures 3 et 4 sont des vues latérales de plaques métalliques respectivement d'un premier et second genres utilisées dans ces dispositifs ;

Les figures 5 et 6 représentent, en perspective et en vue de dessus, des pièces de coincement des plaques métalliques ;

La figure 7 illustre l'application du dispositif à la réalisation d'un pont monophasé inverseur ;

La figure 8 est un schéma équivalent au câblage du montage de la figure 7 ;

La figure 9 illustre une application du dispositif à la réalisation d'un pont onduleur triphasé ;

La figure 10 est un schéma équivalent au câblage du montage des figures 9 et 11 ;

La figure 11 représente un deuxième mode de réalisation du pont onduleur triphasé et son utilisation dans un montage redresseur onduleur triphasé.

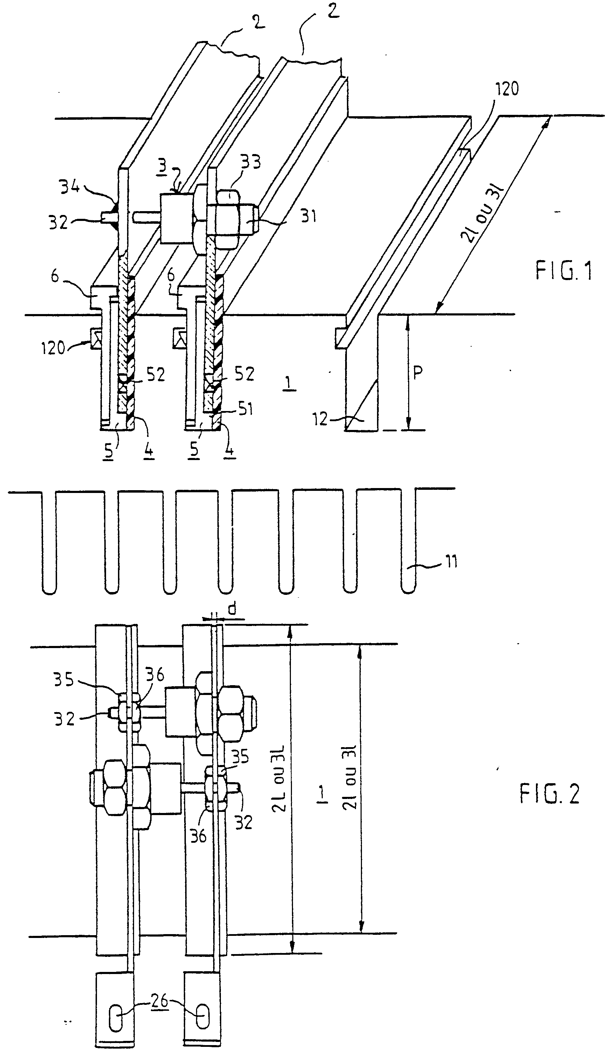

A la figure 1, le numéro de référence 1 désigne un bloc en matériau bon conducteur de la chaleur, par exemple de l'aluminium. Ce bloc de support peut comporter, de façon connue en soi, des ailettes de refroidissement 11 sur sa face inférieure.

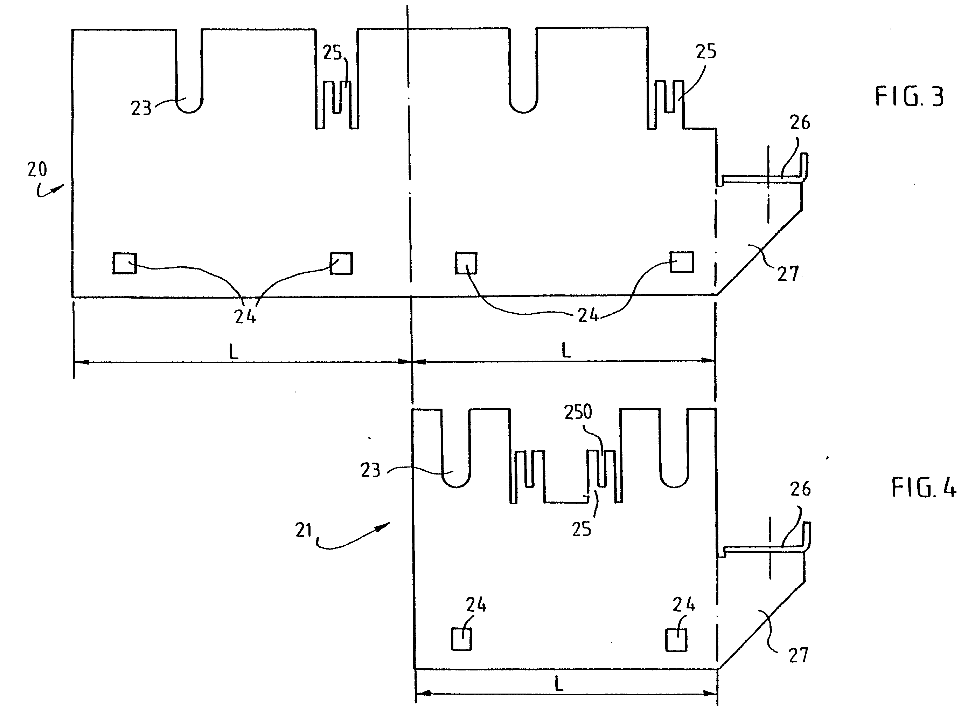

La face supérieure du bloc de support 1, formant le dissipateur thermique, comporte une ou plusieurs rainures verticales, s'étendant à partir de la face supérieure du bloc en direction de sa face inférieure. Une deuxième rainure 120, moins profonde que la première 12, débouche perpendiculairement à celle-ci. En d'autres termes, cette deuxième rainure 120 a son plan de symétrie parallèle au plan de la face supérieure du bloc 1 et débouche dans la première rainure 12. Une ou plusieurs plaques métalliques 2 sont disposées dans chaque rainure 12. Ces plaques sont en matériau bon conducteur de l'électricité et de la chaleur, par exemple en cuivre, et servent de support à au moins un composant électronique 3, fixé par au moins une extrémité à cette plaque. De préférence, on monte au moins deux plaques 2 pour fixer le composant 3 par ses deux extrémités principales. La première extrémité comporte un filetage 31 permettant la fixation par un écrou 33 à une première plaque 2, tandis que la deuxième extrémité 32 est fixée par un point de soudure 34 à une deuxième plaque 2. Les plaques sont disposées dans chaque rainure, espacées d'une distance inférieure à la longueur hors tout du composant 3 et isolées électriquement du bloc dissipateur 1 par une feuille 4 mince et isolante destinée à assurer une bonne conduction thermique et une bonne isolation électrique. L'épaisseur de la feuille 4, inférieure à 250 μm permet de tenir des tensions d'isolement de 2 500 V, tout en assurant une bonne conduction calorifique. Les plaques sont en outre isolées du bloc dissipateur 1 par un ensemble de deux pièces 5, 6, dont une au moins 5 est en matériau isolant. Cette pièce 5 comporte un talon ou épaulement 51 sur lequel vient reposer en appui la plaque 2. Des ergots élastiques 52, solidaires de la cale 5, viennent se loger dans des ouvertures 24 (figures 3 et 4), pratiquées dans la plaque 2. La pièce 6, ayant une fonction de cale, vient fixer par coincement l'ensemble des pièces 2, 4, 5. Cette pièce 6 peut éventuellement ne pas être en matériau isolant et, dans ce cas, elle ne doit pas toucher la plaque 2. Pour réduire les coûts de fabrication, les pièces 5 et 6 seront de préférence identiques et obtenues par moulage d'une matière isolante.

La pièce 6 comporte également des ergots élastiques 62 qui viennent se loger dans la rainure 120 et solidariser l'ensemble formé par la plaque 2, la feuille 4, la cale de support 5 et la cale de coincement 6.

Ainsi, les ergots 52 et 62 évitent que les plaques 2 puissent être extraites du bloc de façon intempestive, et les cales 5 et 6 assurent un bon coincement des plaques 2 et des feuilles 4 contre les parois des rainures 12, de façon à assurer un bon contact thermique.

Dans le cas où le composant de puissance est un composant actif (par exemple, un thyristor) la borne active du composant (par exemple sa gâchette, du thyristor) est reliée directement au fil de commande, tandis que les deux autres bornes (par exemple anode et cathode) sont constituées par les extrémités 31, 32.

A la figure 2, on a représenté un autre mode de fixation de composants de puissance, comportant des filetages à chacune de ses extrémités 32, 31. Dans cette variante, le point de soudure 34 est remplacé par un écrou 35 et un contre-écrou 36. Sur cette figure, on peut voir comment sont montés deux composants en opposition sur deux plaques 2, ainsi que les plages de connexion 26 de ces plaques qui permettent de réaliser les branchements des composants de puissance aux circuits extérieurs.

La forme des plages 26 est prévue pour permettre un raccordement par vissage ou encliquetage d'une cosse.

Les figures 3 et 4 représentent deux modes de réalisation de plaques 2.

Le premier genre de plaque 20 (figure 3) comporte une plage de connexion 26 et un portion de raccordement 27 de la plage à la plaque métallique 20. Celle-ci a une longueur double ou triple de la précédente et comporte au moins une paire de fentes 23 enchevêtrée avec au moins une paire de languettes 25.

Du fait de cet enchevêtrement, on trouve, en partant de la plage de connexion, successivement et alternativement : une languette 25, une fente 23, une deuxième languette 25 et une deuxième fente 23, dans le cas d'une plaque de longueur double. Dans le cas d'une plaque de longueur triple, on trouve ensuite une troisième languette 25, suivie d'une troisième fente 23. Ces plaques de longueurs double ou triple 20, comportent également, suivant les cas, au moins deux ou trois paires d'ouvertures 24. Les languettes 25 découpées dans les plaques 20 ou 21 sont de faible largeur et munies en leur centre d'une fente destinée à recevoir l'extrémité 32 du composant de puissance qui doit y être soudée. La faible dimension de cette languette 25 facilite la soudure, grâce à sa petite capacité thermique ; elle constitue une pièce facilement déformable permettant d'absorber les différences dues à la dilatation, sans effort excessif sur le composant, quand celui-ci est fixé entre deux plaques 21, 20. Les découpes en forme de fente 23 permettent la fixation par serrage du composant de puissance et sont ouvertes, de façon à permettre le montage et le démontage du composant lorsque plusieurs dispositifs identiques 2, 3, 4, 5, 6 sont montés parallèlement dans les rainures 12 d'un bloc dissipateur 1, à une distance inférieure à la longueur hors tout du composant.

Ainsi, la conduction thermique entre le composant 3 et la plaque 2 est grandement améliorée, car il n'y a pas d'isolant et le composant est en contact avec la plaque 2 par toute sa surface arrière et également, par l'écrou de serrage. De même, la conductivité électrique du montage est excellente. Enfin, la conduction calorifique vers l'élément dissipateur est également considérablement améliorée, car la plaque 2 offre une plus grande surface en contact thermique avec l'élément dissipateur 1, à travers la mince feuille d'isolant 4.

Un deuxième genre de plaque 21, de longueur L (figure 4), comporte une plage de connexion 26 et une portion de raccordement 27 de la plage 26 à la plaque 21. Cette dernière est munie d'une paire de trous ou fentes 23, destinés à permettre la fixation d'une extrémité 31 d'un composant de puissance et d'une paire de languettes 25, comportant chacune une fente 250 destinée à recevoir l'autre extrémité 32 du composant de puissance. La paire de languettes 25 est intercalée au milieu d'une paire de fentes 23. La plaque 21 comporte également au moins une paire d'ouvertures 24 qui permettent l'introduction des ergots ou languettes 52.

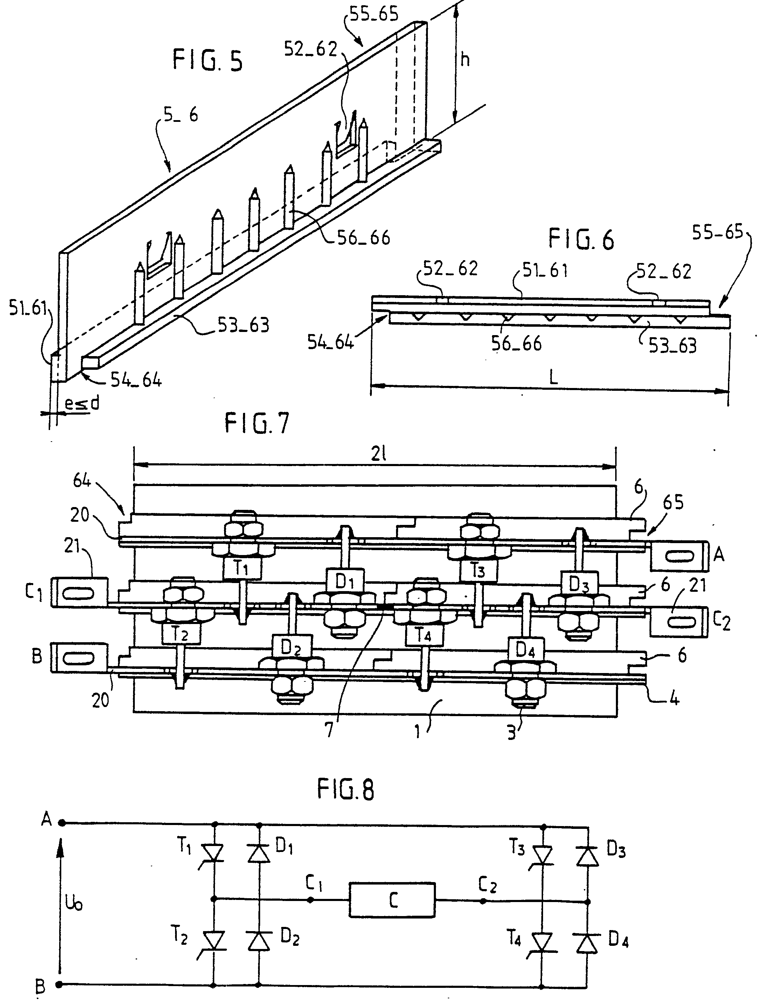

Les figures 5 et 6 représentent les pièces 5, 6 qui constituent les organes de coincement et d'isolation du fond de la rainure. Ces pièces seront de préférence réalisées en matière isolante et moulable facilement. La figure 5 est une vue en perspective de la pièce 5 ou 6 en forme de plaque, comportant sur un de ses bords longitudinaux un talon ou épaulement, 51 ou, respectivement, 61, d'épaisseur e égale ou légèrement inférieure à l'épaisseur d des plaques conductrices 2 (figure 2). La plaque 5 ou 6 a une longueur L et comporte, sur sa face opposée au talon 51, un deuxième talon ou épaulement 53 ou, respectivement, 63. Au moins deux languettes élastiques 52 ou, respectivement, 62, découpées dans la plaque 5 ou, respectivement, 6, forment les ergots saillants du côté du talon 51 ou, respectivement, 61. Les plaques 5 et 6 ont une hauteur h de préférence supérieure à la profondeur p des rainures 12, de façon à augmenter les lignes de fuite et à fournir une face d'appui à l'extérieur de la rainure 12 pour la pièce 6 lors de son enfoncement, afin de faciliter son positionnement. La face des plaques 5 ou, respectivement, 6 tournée vers l'épaulement 53 ou, respectivement, 63 comporte des nervures 56 ou, respectivement, 66, jusqu'à mi-hauteur environ de la plaque 5 ou, respectivement, 6. Les nervures d'une plaque 5 sont disposées de façon à venir s'intercaler entre les nervures d'une plaque 6 lors de l'introduction de la cale et assurent ainsi, par un léger écrasement des nervures, une bonne répartition des pressions, donc des contacts thermiques, tout le long des pièces 2, 4 et 1. Il est bien évident que, pour obtenir le même résultat avec les moyens de fixation et de montage traditionnels, on serait amené à augmenter le nombre de vis de fixation ou de rivets et, par conséquent, les surfaces usinées. En outre, augmenter les usinages équivaut à réduire les surfaces de contact à chaque perçage. De plus, les rivets ou les vis utilisés devraient être, soit en matière isolante, soit munis de canons isolants.

Les pièces 5 ou respectivement, 6 comportent des échancrures 54 ou, respectivement, 64 et 55 ou, respectivement, 65 à chaque extrémité, disposées de façon telle que l'on puisse utiliser un jeu de plusieurs pièces 5 ou, respectivement, 6 pour obtenir la longueur correspondante à la longueur des plaques 2 et du bloc dissipateur 1. En effet, la longueur d'une pièce 5 étant L, en associant deux ou trois pièces successives, on obtiendra des longueurs 2L ou 3L.

Les échancrures 54, 55 sont disposées de façon que l'échancrure 55 de la première pièce 5 vienne s'emboîter dans l'échancrure 54 de la pièce suivante 5 et ainsi de suite, pour augmenter ainsi les lignes de fuites.

De même, pour augmenter les lignes de fuites, la longueur 2L, 3L de la feuille isolante 4 est supérieure à la longueur 21 ou 31 du bloc dissipateur 1, (figure 2), et la hauteur de la feuille isolante 4 est supérieure à la profondeur p des rainures 12 (figure 1).

La figure 7 représente l'application du montage de la figure 1 à la réalisation d'un pont monophasé inverseur. Le schéma de principe d'un tel montage est représenté à la figure 8 et associe, de façon bien connue en soi, des thyristors et des diodes pour alimenter, au moyen d'une source de tension $U_0$ branchées en A et B, une charge C connectée en $C_1$ et $C_2$.

Sur la figure 7, on a indiqué à proximité des plages de connexion 26, les correspondances avec le schéma de la figure 8. De même, on a porté, sur les composants de puissance 3, la correspondance avec le schéma de la figure 8. Le bloc dissipateur 1 de la figure 7, de longueur 21, comporte trois rainures 12 dans lesquelles on a disposé les éléments 2, 4, 5 et 6. L'élément 6 est constitué de deux pièces emboîtées l'une dans l'autre, de la façon indiquée plus haut, grâce aux échancrures 64, 65. Dans la première rainure, on dispose une plaque du premier genre 20 représenté à la figure 3, que l'on connecte à la borne A de l'alimentation. Dans la deuxième rainure, on monte deux plaques du deuxième genre 21 représenté à la figure 4. Ces deux plaques sont séparées par une pièce en matière isolante 7 et sont connectées respectivement aux bornes $C_1$ et $C_2$ de la charge. La troisième rainure reçoit une deuxième plaque du premier genre 20 (figure 3), montée cette fois de façon telle que la plage de connexion (26) débouche du côté opposé à celui de la première plaque 20. Cette plage de connexion est branchée à la borne B de l'alimentation. Les différents composants de puissance sont montés entre les plaques, de la façon représentée à la figure 7.

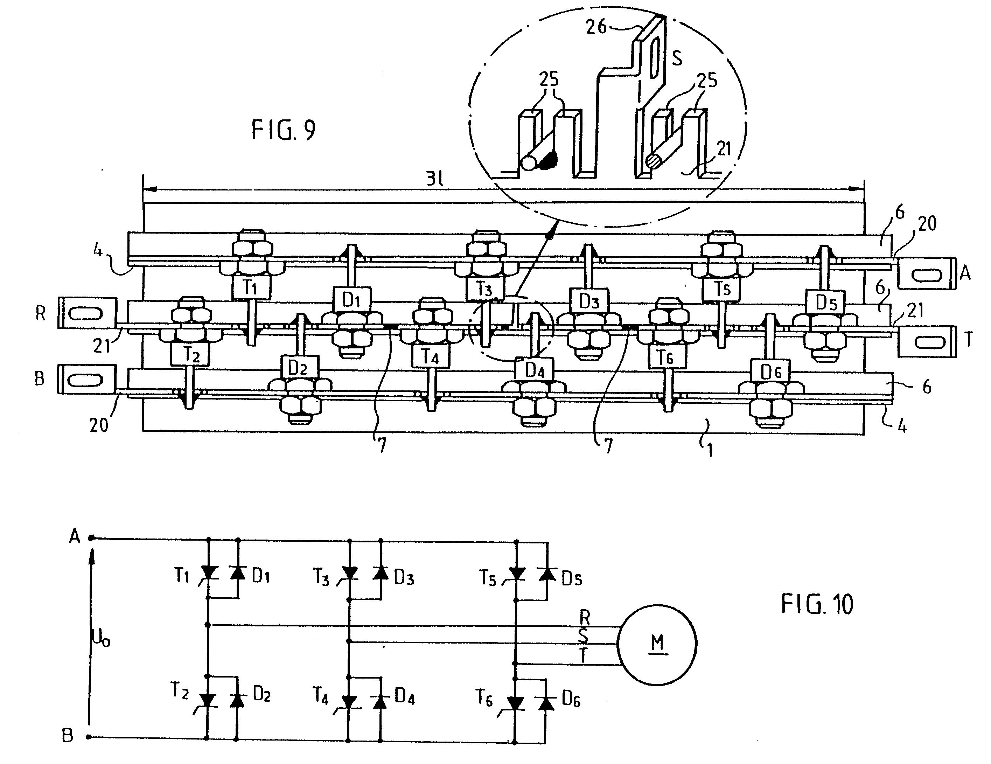

La figure 9 représente le montage de composants suivant le dispositif de l'invention pour constituer un pont triphasé dont le schéma de principe est montré sur la figure 10. Ce pont est branché à une source d'alimentation en tension continue et se branche en R, S, T aux enroulements du moteur M. Le montage représenté à la figure 9 comporte un bloc dissipateur 1 de longueur 31 et pourvu de trois rainures. Dans la première rainure, on monte une plaque 2 du premier genre 20 de la figure 3 et de longueur 3L qui sera branchée à la borne A de la source d'alimentation. Les pièces de calage 6 sont constituées de trois morceaux de longueur L s'emboîtant les uns dans les autres. Dans la deuxième rainure, on dispose trois plaques 2 du deuxième genre 21 de la figure 4. Ces plaques sont séparées et isolées les unes des autres par des éléments isolants 7. Les deux plaques extrêmes sont reliées respectivement aux bornes R et T du moteur, tandis que la plaque centrale est reliée à la borne S du moteur par une plage de connexion représentée de façon agrandie dans une bulle et se substituant aux portions 26 et 27 de la figure 4. La troisième plaque 2 du premier genre 20 de la figure 3 est montée dans la troisième rainure et branchée à la borne B de la source d'alimentation par sa plage de connexion 26, qui se trouve sur le côté de la rainure opposé à celui qui correspond à la plage de la première plaque.

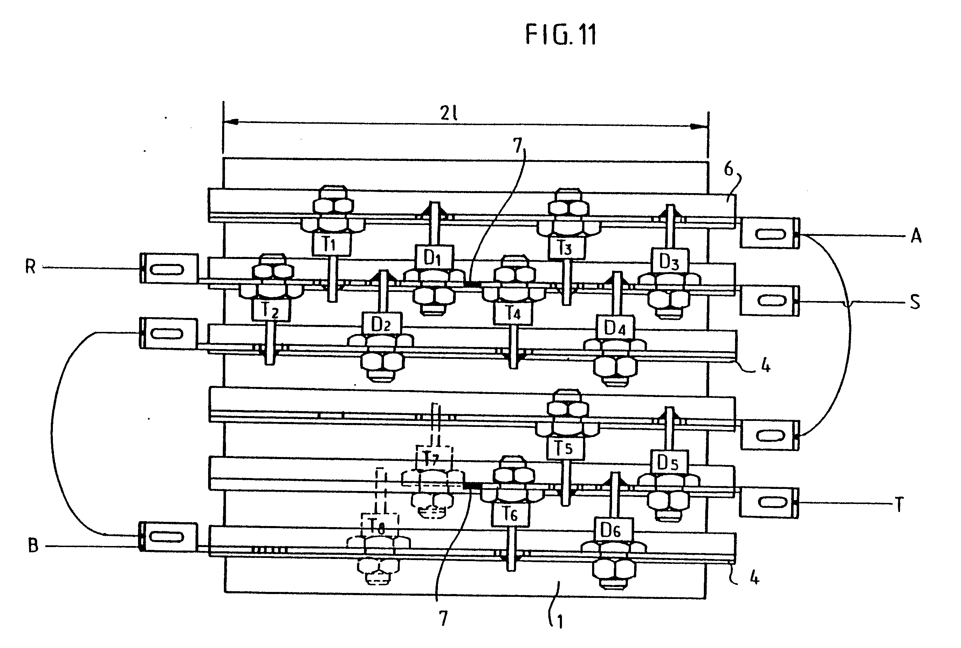

La figure 11 représente un montage permettant le câblage du schéma de la figure 10 sur le bloc dissipateur 1 de longueur 21 et avec deux plaques de longueur L ou 2L. Ce câblage nécessite un bloc 1 avec six rainures et le montage à la première, troisième, quatrième et sixième rainures de plaques du premier genre 20 de la figure 3, les plages de connexion étant alternativement disposées de chaque côté du bloc.

Le montage est ensuite complété par la mise en place, dans la deuxième rainure, de deux plaques du deuxième genre 21 de la figure 4 et d'une plaque du deuxième genre 21 dans la cinquième rainure. Enfin, les plages de connexion sont

raccordées aux différentes bornes du circuit extérieur et entre elles, de la façon représentée à la figure 11. La première plaque est branchée à la borne A et à la quatrième plaque ; les plaques 21 de la deuxième rainure sont branchées aux bornes R, S du moteur ; la plaque 21 et la cinquième rainure est branchée à la borne T du moteur et la plaque de la troisième rainure est branchée à la plaque de la sixième rainure, laquelle est également branchée à la borne B de la source d'alimentation. Les composants sont montés sur chacune des plaques avec les orientations indiquées sur chacune des figures 7, 9 et 11. Ces orientations sont dictées par les dispositions respectives des fentes 23 et des languettes 25 des différentes plaques.

Dans l'ensemble des figures, on a représenté des composants de puissance qui sont montés sur les plaques avec une soudure à une extrémité et par serrage par un écrou à l'autre extrémité ; mais il est bien évident que l'invention s'applique aussi bien à des composants dont les deux extrémités seraient soudées ou dont les deux extrémités seraient fixées par serrage, comme le représente la figure 2.

Le montage de la figure 11 est particulièrement avantageux lorsque l'on veut associer un onduleur tel que, représenté à la figure 10, avec un montage redresseur non représenté. On peut alors utiliser la place disponible sur les rainures 4 à 6 pour monter les composants semi-conducteurs actifs correspondant à une phase du redresseur, comme on l'a représenté en pointillé à la figure 11 et compléter le montage par trois autres rainures pour les deux autres phases du redresseur. Comme on peut le voir, le redresseur ne comporte pas de composants semi-conducteurs passifs.

Les plaques de la septième et de la neuvième rainures sont respectivement branchées aux plaques de la quatrième et de la sixième rainures. Les plaques des cinquième et huitième rainures sont branchées aux trois phases d'une alimentation triphasée. Dans ce montage, il n'est donc plus nécessaire de brancher la plaque de la première rainure à la borne A et la plaque de la sixième rainure à la borne B.

**Revendications**

1. Dispositif d'assemblage de composants électroniques de puissance sur un bloc dissipateur thermique, comprenant un tel bloc dissipateur et un ensemble de supports de composants de puissance montés sur le bloc, et permettant la transmission calorifique des composants de puissance au bloc dissipateur, caractérisé en ce que chaque support est constitué d'une plaque (2) entièrement métallique portant directement les composants de puissance (3) et reliée électriquement par une plage de connexion à une source d'alimentation des composants de puissance, et que les plaques métalliques (2) et, entre lesquelles sont connectés lesdits composants de puissance, sont coincées dans des rainures (12) formées dans ledit bloc dissipateur, chaque plaque (2) étant coincée au moyen d'un organe de coincement et d'isolation (5, 6) en même temps qu'une feuille mince (4) d'isolement électrique et de transmission calorifique interposée entre ladite plaque (2) et une paroi de la rainure (12).

2. Dispositif selon la revendication 1, caractérisé en ce que l'organe de coincement et d'isolation (5, 6) comprend une pièce isolante (5) placée au fond de la rainure, comportant un épaulement (51) sur lequel vient s'appuyer la plaque (2) et comportant une surface plane d'isolation parallèle au plan de la plaque (2) ; et une deuxième pièce (6) introduite par le haut de la rainure et assurant par déplacement vers le bas le coincement dans la rainure des différentes pièces (5), (2), (4).

3. Dispositif selon la revendication 2, caractérisé en ce que l'une des pièces (5), (6) comporte des nervures déformables par écrasement, pour assurer une bonne répartition de l'effort de serrage de la plaque (2) contre une face de la rainure.

4. Dispositif selon la revendication 2, caractérisé en ce que les pièces (5), (6) sont isolantes et comportent des nervures (56, 66).

5. Dispositif selon l'une des revendications 2 à 4, caractérisé en ce que la largeur de l'épaulement (51) est légèrement inférieure à l'épaisseur de la plaque (2).

6. Dispositif selon l'une des revendications 3 à 5, caractérisé en ce que la feuille isolante (4) et la pièce (5) ont une hauteur supérieure à la profondeur de la rainure (12).

7. Dispositif selon l'une des revendications 2 à 6, caractérisé en ce que les pièces (5), (6) comportent des échancrures (54, 59, 64, 65) permettant de les emboîter bout à bout pour réaliser des tronçons de plus grande longueur tout en augmentant la ligne de fuite.

8. Dispositif selon l'une des revendications 2 à 7, caractérisé en ce que chaque pièce (5), (6) comporte une ou plusieurs languettes (52), (62) venant se loger lors du montage du dispositif dans des ouvertures (24) prévues sur les plaques et dans des rainures (120), prévues dans le bloc, de plan de symétrie perpendiculaire au plan de symétrie de la rainure (12) et débouchant dans la rainure (12) sur la face opposée à la face en contact avec la plaque (2) par l'intermédiaire de la feuille isolante.

9. Dispositif selon l'une des revendications précédentes, caractérisé en ce que la feuille est d'une épaisseur inférieure à 250 μm.

10. Dispositif selon l'une des revendications précédentes, caractérisé en ce que la plaque métallique (2) comporte au moins une découpe en forme de fente (23) et au moins une découpe en forme de languette (25) fendue en son milieu (250).

11. Dispositif selon la revendication 10, caractérisé en ce que la plaque métallique appartient, soit à un premier genre (20) comportant au moins une paire de fentes (23) et au moins une paire de languettes, les fentes et les languettes étant disposées de façon alternée le long de la plaque, soit à un deuxième genre (21) comportant une paire de languettes (25) disposée entre deux fentes (23).

12. Dispositif selon la revendication 11, caractérisé en ce que le bloc dissipateur (1) comprend au moins trois rainures (12) recevant chacune au moins une plaque (2) ; des plaques d'un premier genre (20) sont disposées dans la première et troisième rainures et ces plaques ont leurs plages de connexion (26) orientées dans des directions opposées, tandis que la deuxième rainure reçoit deux plaques d'un second genre (21) séparées par une portion isolante (7).

13. Application du dispositif selon la revendication 12 à la constitution d'un pont monophasé, caractérisé en ce que les composants de puissance du pont sont montés entre les languettes d'une plaque et les fentes d'une autre plaque et fixés, soit par soudure, soit par serrage ; les plages de connexion (26) des première et troisième plaques sont branchées à une source d'alimentation et les plages de connexion des deux plaques de la rainure médiane sont reliées à une charge.

14. Dispositif selon la revendication 11, caractérisé en ce que le bloc dissipateur comprend au moins six rainures recevant chacune au moins une plaque (2) ; des plaques d'un premier genre (20) sont disposées dans les première, troisième, quatrième et sixième rainures et ont leurs plages de connexion (26) orientées alternativement dans des directions opposées ; des plaques d'un second genre (21) sont disposées dans la deuxième et la cinquième rainures, la deuxième rainure comportant deux plaques (21) dont les plages de connexion sont orientées dans des directions opposées.

15. Application du dispositif selon la revendication 14, à la constitution d'un onduleur triphasé, caractérisé en ce que les composants de puissance de l'onduleur sont montés entre les languettes (25) d'une plaque et les fentes (23) d'une autre plaque et fixés par soudure ou serrage ; les plages de connexion des première et troisième plaques sont respectivement reliées, d'une part aux bornes d'une source d'alimentation et, d'autre part, aux plages de connexion des quatrième et sixième plaques ; les plages de connexion des trois plaques du second genre sont reliées aux trois bornes d'une charge.

16. Dispositif selon la revendication 11, caractérisé en ce que le bloc dissipateur comprend au moins neuf rainures recevant chacune au moins une plaque (2) ; des plaques d'un premier genre (20) sont disposées dans les première, troisième, quatrième, sixième, septième et neuvième rainures et ont leurs plages de connexion orientées alternativement dans des directions opposées ; deux plaques d'un second genre (21) sont disposées dans chaque deuxième, cinquième et huitième rainures et ont leurs plages de connexion orientées vers chaque extrémité de la rainure.

17. Application du dispositif selon la revendication 16 à la constitution d'un redresseur-onduleur triphasé, caractérisé en ce que les composants de puissance du redresseur-onduleur sont montés entre les languettes (25) d'une plaque et les fentes (23) d'une autre plaque et fixés par soudure ou vissage, les plages de connexion des quatrième et sixième plaques sont connectées, d'une part, respectivement aux plages de la première et de la troisième plaques et, d'autre part, respectivement à la septième et à la neuvième plaques, les plages de connexion des trois plaques du second genre (21) supportant des composants redresseurs passifs sont branchées aux bornes d'une charge, tandis que les plages de connexion des trois plaques de second genre (21) ne supportant pas de redresseur passif sont branchées aux bornes d'une source d'alimentation triphasée.

## Claims

1. An assembling device for power electronic components on a heat sink unit comprising this latter and an assembly of supports for power components mounted on the unit and providing the heat transmission from the power components to the heat sink, characterized in that each support is formed by an entirely metallic plate (2) directly bearing the power components (3) and electrically connected by a connection surface portion to a supply source for the power components, and in that the metal plates (2) between which are connected the said power components are wedged in grooves (12) formed in said heat sink unit, each plate (2) being wedged by means of a wedging and isolating member (5, 6) together with a thin electrically isolating and heat transmitting sheet (4) interposed between said plate (2) and a wall of the groove (12).

2. The device according to claim 1, characterized in that the wedging and isolating member (5, 6) comprises an isolating piece (5) placed at the bottom of the groove, comprising a shoulder (51) on which the plate (2) comes to bear and which comprises a plane isolating surface parallel to the plate (2) plane ; and a second piece (6) introduced at the top of the groove and achieving, by its downward movement, the wedging in the groove of the different parts (5), (2), (4).

3. The device according to claim 2, characterized in that one of parts (5) (6) comprises ribs which are deformable by crushing, in order to obtain a good distribution of the effort for securing the plate (2) to one face of the groove.

4. The device according to claim 2, characterized in that the parts (5) (6) are isolating parts and have ribs (56, 66).

5. The device according to one of claims 2 to 4, characterized in that the width of the shoulder (51) is slightly less than the thickness of the plate (2).

6. The device according to one of claims 3 to 5, characterized in that the height of the isolating sheet (4) and the part (5) is greater than the depht of the groove (12).

7. The device according to one of claims 2 to 6, characterized in that the parts (5) (6) comprise cut-out spaces (54, 59, 64, 65) for fitting them together end to end, in order to obtain sections of greater length, while increasing the leakage path.

8. The device according to one of claims 2 to 7, characterized in that each part (5) (6) comprises one or more tongues (52) (62) lodging themselves, during the mounting of the device, in openings (24) provided on the plates and in grooves (120) provided in the unit, whose plane of symmetry is perpendicular to the plane of symmetry of the groove (12) and ending in the groove (12) on the face opposite the one in contact with the plate (2) by means of the isolating sheet.

9. The device according to one of the preceding claims, characterized in that the thickness of the sheet is less than 250 $\mu$m.

10. The device according to one of the preceding claims, characterized in that the metal plate (2) comprises at least a cut-out part in the form of a slot (23) and at least a cut-out part in the form of a tongue (25) split in its middle (250).

11. The device according to claim 10, characterized in that the metal plate belongs either to a first type (20) comprising at least two slots (23) and at least two tongues, the slots and the tongues being placed alternately along the plate, or to a second type (21) comprising two tongues (25) placed between two slots (23).

12. The device according to claim 11, characterized in that the heat sink unit (1) comprises at least three grooves (12), each receiving at least one plate (2) ; the lates of a first type (20) are placed in the first and third grooves and the connection faces (26) of these plates are oriented in opposite directions, whereas the second groove receives two plates of a second type (21) separated by an isolating portion.

13. Application of the device according to claim 12 for forming a monophase bridge, characterized in that the power components of the bridge are mounted between the tongues of a plate and the slots of another plate and fixed, either by soldering or by clamping ; the connection surfaces (26) of the first and third plates are connected to a supply source and the connection surfaces of the two plates placed in the middle groove are connected to a load.

14. The device according to claim 11, characterized in that the heat sink unit comprises at least six grooves, each receiving at least one plate (2) ; plates of a first type (20) are placed in the first, third, fourth and sixth grooves and their connection faces (26) are alternately oriented in opposite directions ; plates of a second type (21) are placed in the second and fifth grooves, the second groove comprising two plates (21) whose connection surfaces are oriented in opposite directions.

15. Application of the device according to claim 14 for forming a three-phase inverter, characterized in that the power components of the inverter are mounted between the tongues (25) of a plate and the slots (23) of another plate and fixed by soldering or clamping, the connection faces of the first and third plates are respectively connected, on the one hand, to the terminals of a supply source and, on the other hand, to the connection surfaces of the fourth and sixth plates ; the connection surfaces of the three plates of the second type are connected to the three terminals of a load.

16. The device according to claim 11, characterized in that the heat sink unit comprises at least nine grooves, each receiving at least one plate (2) ; plates of a first type (20) are placed in the first, third, fourth, sixth, seventh, and nineth grooves and their connection surfaces are alternately oriented in opposite directions ; two plates of a second type (21) are placed respectively in each second, fifth and eighth groove and their connection surfaces are oriented towards each end of the groove.

17. Application of the device according to claim 16 to the construction of a three-phase rectifier-inverter, characterized in that the power components of the rectifier-inverter are mounted between the tongues (25) of a plate and the slots (23) of another plate and fixed by soldering or screwing, the connection surfaces of the fourth and sixth plates are connected, on the one hand, respectively to the surfaces of the first and third plates and, on the other hand, respectively to the seventh and nineth plates, the connection surfaces of the three plates of the second type (21) bearing passive rectifier components being connected to the terminals of a load, whereas the connection surfaces of the three plates of the second type (21) which are not bearing a passive rectifier are connected to the terminals of a three-phase supply source.

**Patentansprüche**

1. Zusammenbauanordnung für elektronische Leistungsbauelemente auf einem Kühlkörper, mit einem solchen Kühlkörper und einer Trägereinheit für die auf dem Kühlkörper angebrachten Leistungsbauelemente, welche die Wärmeübertragung von den Leistungselementen zum Kühlkörper ermöglicht, dadurch gekennzeichnet, dass jeder Träger aus einer rein metallischen Platte (2) besteht, welche direkt die Leistungselemente (3) trägt und durch eine Anschlussfläche elektrisch an eine Versorgungsquelle für die Leistungselemente angeschlossen ist, und dass die Metallplatten (2), zwischen denen die besagten Leistungselemente angeschlossen sind, in im besagten Kühlkörper geformten Rinnen (12) eingeklemmt sind, wobei jede Platte (2) eingeklemmt ist durch ein Klemm- und Isoliermittel (5, 6), zusammen mit einer dünnen elektrischen Isolier- und Wärmeübertragungsfolie, (4), welche zwischen besagter Platte (2) und einer Wand der Rinne (12) eingelassen ist.

2. Anordnung nach Anspruch 1, dadurch gekennzeichnet, dass zu dem Klemm- und Isoliermittel (5, 6) ein auf dem Boden der Rinne angebrachtes Isolierteil (5) gehört, mit einem Absatz (51) auf dem die Platte (2) aufliegt und einer ebenen, zur Platten (2) ebene parallelen, Isolierfläche und einem zweiten Teil (6), das von oben in die Rinne eingeführt wird und, durch eine Abwärtsbewegung, die Einklemmung der verschiedenen (5) (2) (4) in der Rinne bewirkt.

3. Anordnung nach Anspruch 2, dadurch gekennzeichnet, dass eines der Mittel (5) (6) durch Druck verformbare Rippen besitzt, um eine gute Verteilung der Kräfte zur Festklemmung der Platte (2) gegen eine Rinnenwand zu bewirken.

4. Anordnung nach Anspruch 2, dadurch gekennzeichnet, dass es sich bei den Mitteln (5) (6) um Isoliermittel handelt und diese Rippen (56, 66) besitzen.

5. Anordnung nach einem der Ansprüche 2 bis 4, dadurch gekennzeichnet, dass die Breite des Absatzes (51) um ein weniges geringer ist, als die Platten (2) dicke.

6. Anordnung nach einem der Ansprüche 3 bis 5, dadurch gekennzeichnet, dass die Höhe der Isolierfolie (4) und des Mittels (5) grösser ist, als die Rinnen (12)-tiefe.

7. Anordnung nach einem der Ansprüche 2 bis 6, dadurch gekennzeichnet, dass die Mittel (5) (6) Ausschnitte (54, 59, 64, 65) besitzen, die es ermöglichen, sie aneinanderzufügen, um so grössere Abschnitte zu erhalten und gleichzeitig die Streuverluststrecke zu vergrössern.

8. Anordnung nach einem der Ansprüche 2 bis 7, dadurch gekennzeichnet, dass jedes Mittel (5) (6) mit einer oder mehreren Zungen (52) (62) versehen ist, die, beim Zusammenbau der Anordnung, in auf den Platten vorgesehene Öffnungen (24) eindringen und in Rinnen (120) im Kühlkörper, deren Symmetrieebene senkrecht zur Symmetrieebene der Rinne (12) verläuft und die in die Rinne (12) auf der Seite einmünden, die gegenüber der durch die Isolierfolie mit der Platte (2) in Kontakt befindlichen liegt.

9. Anordnung nach einem der vorhergehenden Ansprüche, dadurch gekennzeichnet, dass die Folie weniger als 250 μm dick ist.

10. Anordnung nach einem der vorhergehenden Ansprüche, dadurch gekennzeichnet, dass in der Metallplatte (2) mindestens ein Ausschnitt in Form eines Schlitzes (23) angebracht ist und mindestens ein Ausschnitt in Form einer in der Mitte (250) aufgeschlitzten Lamelle (25).

11. Anordnung nach Anspruch 10, dadurch gekennzeichnet, dass die Metallplatte entweder zu einer ersten Sorte (20) gehört, mit mindestens einem Paar von Schlitzen (23) und mindestens einem Paar von Lamellen, wobei die Schlitze und die Lamellen abwechselnd entlang der Platte angeordnet sind, oder aber zu einer zweiten Sorte (21), mit einem Paar von Lamellen (25), welche zwischen zwei Schlitzen (23) angeordnet ist.

12. Anordnung nach Anspruch 11, dadurch gekennzeichnet, dass der Kühlkörper (1) mindestens drei Rinnen (12) hat, die jede mindestens eine Platte (2) aufnehmen ; Platten des ersten Typs (20) sind in die erste und dritte Rinne eingesetzt und die Anschlussflächen (26) dieser Platten weisen in entgegengesetzte Richtungen, während die zweite Rinne zwei, durch eine Isolierfläche (17) getrennte Platten des zweiten Typs (21) aufnimmt.

13. Anwendung der Anordnung nach Anspruch 12 auf die Bildung einer Einphasenbrücke, dadurch gekennzeichnet, dass die Leistungselemente der Brücke zwischen die Lamellen einer Platte und die Schlitze einer anderen Platte eingebaut und entweder durch Schweissen oder Klemmen befestigt sind ; die Anschlussflächen (26) der ersten und dritten Platte sind an eine Versorgungsquelle angeschlossen und die Anschlussflächen der beiden Platten der mittleren Rinne sind an eine Last angeschlossen.

14. Anordnung nach Anspruch 11, dadurch gekennzeichnet, dass der Kühlkörper mindestens sechs Rinnen hat, die jeweils mindestens eine Platte (2) aufnehmen ; Platten der ersten Art (20) sind in die erste, dritte, vierte und sechste Rinnen eingesetzt, und ihre Anschlussflächen (26) weisen abwechselnd in entgegengesetzte Richtungen ; Platten der zweiten Art (21) sind in die zweite und fünfte Rinne eingesetzt, wobei die zweite Rinne zwei Platten (21) aufnimmt, deren Anschlussflächen in entgegengesetzte Richtungen weisen.

15. Anwendung der Anordnung nach Anspruch 14 auf die Bildung eines Dreiphasenwechselrichters, dadurch gekennzeichnet, dass die Leistungselemente des Wechselrichters zwischen den Lamellen (25) einer Platte und den Schlitzen (23) einer anderen Platte eingebaut und durch Schweissen oder Klemmen befestigt sind ; die Anschlussfächen der ersten und dritten Platte sind jeweils einerseits an die Klemmen einer Versorgungsquelle und andererseits an die Anschlussflächen der vierten und sechsten Platte angeschlossen, die Anschlussflächen der drei Platten der zweiten Art sind an die drei Klemmen einer Last angeschlossen.

16. Anordnung nach Anspruch 11, dadurch gekennzeichnet, dass der Kühlkörper mindestens neun Rinnen besitzt, die jeweils mindestens eine Platte (2) aufnehmen ; Platten der ersten Art (20) sind in die erste, dritte, vierte, sechste, siebte und neunte Rinne eingesetzt und ihre Anschlussflächen weisen abwechselnd in entgegengesetzte Richtungen ; zwei Platten einer zweiten Art (21) sind in jede zweite, fünfte und achte Rinne eingesetzt und ihre Anschlussflächen sind auf jedes der Rillenenden hin gerichtet.

17. Anwendung der Anordnung nach Anspruch 16 auf die Bildung eines Dreiphasen-Gleichrichters/Wechselrichters, dadurch gekennzeichnet, dass die Leistungselemente des Gleichrichters/Wechselrichters zwischen die Lamellen (25) einer Platte und die Schlitze (23) einer anderen Platte eingebaut und durch Schweissen oder Schrauben befestigt sind, wobei die Anschlussflächen der vierten und sechsten Platte jeweils einerseits an die Anschlussflächen der ersten und der dritten Platte angeschlossen sind und andererseits jeweils an die siebte und neunte Platte, und die Anschlussflächen der drei Platten der zweiten Art (21), welche passive Gleichrichterelemente tragen, an die Klemmen einer Last angeschlossen sind, während die Anschlussflächen der drei Platten der zweiten Art (21), welche keinen passiven Gleichrichter tragen, an die Klemmen einer Dreiphasenspeisequelle angeschlossen sind.

**0 119 134**

FIG.1

FIG.2

FIG. 3

FIG. 4

0 119 134

0 119 134

FIG. 5

FIG. 6

FIG. 7

FIG. 8

3

FIG. 9

FIG. 10

FIG.11